# FASCICULE DE BREVET EUROPEEN

(11) **EP 3 275 083 B1**
(45) Date de publication et mention de la délivrance du brevet: **01.05.2019**
(21) Numéro de dépôt: 16714795.8
(22) Date de dépôt: 22.03.2016
(51) Int. Cl.: H04B 3/56, H01F 38/14, H03H 7/01, H04B 3/54, H04L 25/02

(54) **COUPLEUR ÉLECTRIQUE PUISSANCE/DONNÉES**
STROM-/DATEN-ELEKTROVERBINDER
POWER/DATA ELECTRICAL COUPLER

(30) Priorité: 25.03.2015 FR 1552498
(43) Date de publication de la demande: 31.01.2018
(73) Titulaire: Safran Electronics & Defense SAS, 92100 Boulogne-Billancourt (FR)
(72) Inventeur: GUILLOT, François, 92100 Boulogne Billancourt (FR)
(74) Mandataire: Cabinet Le Guen Maillet
(86) Numéro de dépôt international: PCT/EP2016/056272
(87) Numéro de publication internationale: WO 2016/150970

(56) Documents cités:
- CA-A1- 2 699 584
- FR-A1- 2 937 199
- FR-A1- 2 993 106

## Description

La présente invention concerne un coupleur électrique puissance/données. Un tel coupleur électrique est prévu pour émettre sur un bus bifilaire des signaux de données délivrés par une unité de commande ou recevoir des signaux de données dudit bus bifilaire et les délivrer à une unité de commande. Il est également prévu pour délivrer audit bus bifilaire un potentiel d'alimentation ou recevoir dudit bus bifilaire un potentiel d'alimentation. Un tel coupleur puissance/données est par exemple utilisé pour coupler, via des bus bifilaires, des actionneurs électriques à des unités de commande et à des alimentations de puissance en formant un réseau de transport de données et d'alimentation. De tels réseaux sont par exemple embarqués sur des aéronefs.

Comme on le comprendra par la suite, lorsqu'ils sont regroupés par deux, des coupleurs électriques selon l'invention forment ce qui est appelé un système de couplage.

Divers modes de réalisation de tels coupleurs électriques puissance/données sont connus et on pourra se reporter, à titre d'exemples, à ceux qui sont décrits dans les publications de brevet CA2699584, FR2993106 et FR2937199. Un autre mode de réalisation équivalent est décrit en relation avec la Fig. 1 afin de mieux présenter le problème que la présente invention cherche à résoudre.

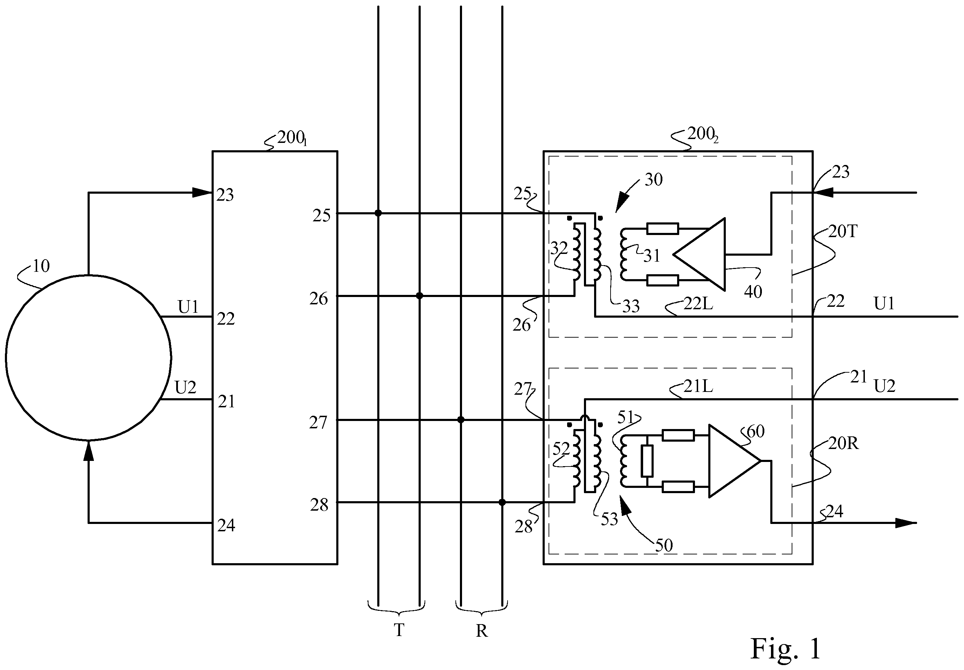

On a représenté à la Fig. 1 une partie d'un tel réseau de transport de données et d'alimentation, laquelle comprend un actionneur 10 et deux systèmes de couplage 200₁ et 200₂. L'actionneur 10 est relié au système 200₁, d'une part, pour y être alimenté en puissance par des plots 21 et 22 respectivement portés à des premier et second potentiels U1 et U2 et, d'autre part, pour émettre des données sur le réseau via le plot 23, ou pour recevoir des données du réseau via le plot 24. De même, le système de couplage 200₂ comporte des plots 21 et 22, soit pour alimenter un actionneur (non représenté) branché sur lesdits plots 21 et 22, soit portés à un premier et second potentiels d'alimentation U1 et U2 d'une source d'alimentation (non représentée). Il comporte encore des plots 23 et 24 pour respectivement recevoir et émettre des signaux de données, par exemple d'un périphérique tel qu'un actionneur ou une unité de commande, telle qu'un ordinateur. Les systèmes de couplage 200₁ et 200₂ sont reliés, via leurs plots respectifs 25, 26, 27 et 28 à deux paires de fils T et R pour le transport respectifs des signaux de données qui sont émis par un actionneur ou une unité de commande et des signaux de données qui sont à destination des actionneurs ou unités de commande du réseau. D'autres systèmes de couplage électriques que ceux représentés peuvent être connectés aux paires de fils T et R pour d'autres actionneurs ou unités de commande, ces paires de fils T et R formant chacune alors un bus bifilaire. De plus, chaque fil d'une paire de fils T, R est porté à un potentiel d'alimentation U1; U2 et transporte ainsi le courant d'alimentation issu d'une source d'alimentation vers les actionneurs. Comme on le verra par la suite, alors que les données sont transportées sur les bus bifilaires T et R en mode différentiel, le courant d'alimentation est lui transporté en mode commun.

A la Fig. 1, la structure du système de couplage 200₂ est détaillée. Il comporte deux coupleurs électriques 20T et 20R. Le coupleur électrique 20T est dédié à l'émission de signaux de données sur le bus bifilaire T. Pour ce faire, il est relié audit bus bifilaire T pour y émettre les signaux de données qui sont délivrés par une unité de commande (non représentée) connectée au plot 23. Par ailleurs, le potentiel d'alimentation U1 sur le plot 23 est celui de chacun des fils du bus bifilaire T. Le second coupleur 20R est dédié à la réception de signaux de données présents sur le bus bifilaire R. Pour ce faire, il est relié audit bus bifilaire R pour y recevoir ses signaux de données et pour les délivrer à une unité de commande (non représentée) connectée au plot 24. Par ailleurs, le potentiel d'alimentation U2 sur le plot 21 est celui de chacun des fils dudit bus bifilaire R.

Le coupleur électrique 20T comprend un premier transformateur 30 dont les bornes d'un enroulement 31 sont reliées, via des résistances d'adaptation d'impédances respectives, à deux sorties d'un amplificateur 40 recevant sur son entrée le signal de données présent sur le plot 23. Cet enroulement 31 crée un flux magnétique qui excite deux autres enroulements identiques 32 et 33 du transformateur 30. Ces enroulements 32 et 33 sont reliés en série entre eux avec une borne commune et deux autres bornes reliées aux plots 25 et 26 et ainsi à la paire de fils T. Ils sont enroulés de manière qu'ils reçoivent le même flux magnétique de l'enroulement 31 et délivrent le même signal à leurs bornes (voir la représentation à cet effet par des points symboliques). La borne commune des deux enroulements 32 et 33 est reliée au plot 22 du coupleur 20T par une ligne d'alimentation 22L pour y recevoir ou délivrer, selon le mode d'utilisation du coupleur électrique en question, un potentiel U1 d'alimentation.

De même, le coupleur électrique 20R comporte encore un second transformateur 50 dont deux enroulements identiques 52 et 53 sont reliés en série entre eux avec une borne commune et deux autres bornes reliées aux plots 27 et 28 et ainsi à la paire de fils R. Il comporte un troisième enroulement 51 dont les bornes sont reliées, via des résistances d'adaptation d'impédances, aux entrées d'un amplificateur 60 dont la sortie est reliée au plot 24 du coupleur électrique 20R pour délivrer des données à un périphérique. Les enroulements 52 et 53 sont enroulés de manière que leurs flux magnétiques respectifs s'additionnent pour exciter l'enroulement 51 (voir les points symboliques à cet effet). La borne commune des deux enroulements 52 et 53 est reliée au plot 21 du coupleur par une ligne d'alimentation 21L pour y recevoir ou délivrer, selon l'utilisation faite du coupleur, un potentiel U2 d'alimentation.

Lorsqu'une source d'alimentation est connectée aux plots 21 et 22, le potentiel U1 se retrouve, via chacun des enroulements 32 et 33, sur chacun des fils de la paire de fils T et le potentiel U2 se retrouve quant à lui, via chacun des enroulements 52 et 53, sur chacun des fils de la paire de fils R. A l'inverse, lorsqu'un actionneur est connecté aux plots 21 et 22, le potentiel U1 présent sur chacun des fils de la paire T se retrouve au point commun des enroulements 32 et 33 et donc sur la ligne d'alimentation 22L et le plot 22 et le potentiel U2 présent sur chacun des fils de la paire R se retrouve au point commun des enroulements 52 et 53 et donc sur la ligne d'alimentation 22L et le plot 21. Il s'agit ici du mode commun.

Les signaux de données présents sur le plot 23, après amplification par l'amplificateur 40, excitent l'enroulement 31, lequel génère un flux magnétique qui est capté par les enroulements 32 et 33, lesquels génèrent, sur les fils respectifs de la paire de fils T, des signaux de données d'amplitudes opposées. De même, les signaux de données d'amplitudes opposées respectivement présents sur les fils de la paire de fils R génèrent des flux magnétiques dont les amplitudes absolues s'additionnent dans les enroulements 52 et 53, excitant alors l'enroulement 51 qui engendre alors un signal de données différentiel qui, après amplification par l'amplificateur 60, est fourni au plot 24 à destination d'un périphérique. Il s'agit alors du mode différentiel.

Ainsi, les données sont transportées sur les paires de fils R et T en mode différentiel alors que le courant d'alimentation, dans un sens ou l'autre, est lui transporté en mode commun.

La tension engendrée par la différence des potentiels d'alimentation U1 et U2 et constituant l'alimentation des actionneurs, peut être continue ou alternative à relativement faible fréquence (par exemple inférieure à 1 MHz) alors que la fréquence de transmission des données peut être plus élevée (par exemple, quelques centaines de MHz, pour une transmission de type Ethernet).

On notera qu'un système de couplage particulier pourrait ne comprendre qu'un seul coupleur électrique qui serait alors dédié soit à l'émission de signaux de données sur le bus bifilaire T, soit à la réception de signaux de données présents sur le bus bifilaire R.

Cette structure particulière de chaque coupleur électrique, tel que les coupleurs électriques 20R et 20T de la Fig. 1, peut poser des problèmes lorsque des courants à hautes fréquences parasites circulent sur les bus bifilaires T ou R. Cela peut être le cas en cas de foudre frappant l'aéronef dans lequel est embarqué le réseau comprenant le système de couplage incluant le ou lesdits coupleurs électriques considérés et des bus R et T ou, encore, lors de tests hautes fréquences tels que ceux qui sont recommandés par la norme DO-160. Ces courants hautes fréquences se retrouvent sur les lignes d'alimentation 22L et 21L et peuvent endommager la source d'alimentation ou le périphérique qui est connecté aux plots 21 et 22 du système de couplage 200₂. Ils peuvent également endommager les amplificateurs 40 et 60.

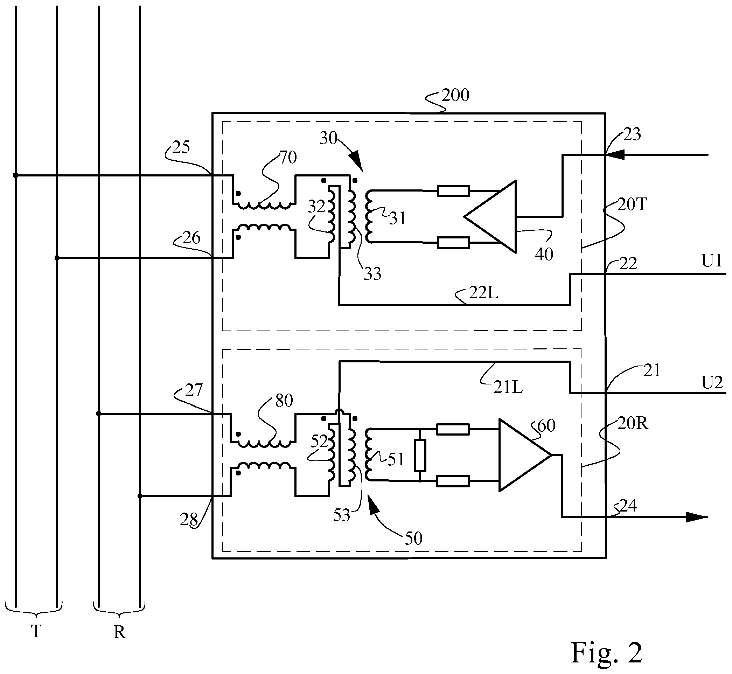

Un autre mode de réalisation de l'état de la technique est représenté à la Fig. 2. Les mêmes éléments que ceux de la Fig. 1 portent les mêmes références. Pour la voie correspondant au bus bifilaire T, le coupleur électrique 20T du système de couplage 200 représenté comporte, en plus des éléments déjà présents à la Fig. 1, un transformateur d'isolement 70 constitué de deux enroulements identiques couplés magnétiquement, dont les bornes d'entrée (marquées par un point) sont reliées aux plots 25 et 26 du système de couplage 200 destinés à être reliés au bus bifilaire T et dont les bornes de sortie sont respectivement reliées aux bornes des enroulements 32 et 33 du transformateur 30. Les signaux transmis par ce transformateur 70 en mode commun sont fortement atténués alors qu'en mode différentiel ils ne le sont pas. Les signaux de données à hautes fréquences sont transmis en mode différentiel (leurs potentiels sur les fils du bus T sont différents) et ne sont donc pas perturbés par le transformateur 70. Par contre, les signaux parasites à hautes fréquences sont transmis en mode commun (leurs potentiels sur les fils du bus T sont sensiblement égaux) si bien qu'ils sont fortement atténués aux bornes des enroulements 32 et 33 du transformateur 30.

De même, pour la voie correspondant à la paire de fils R, le coupleur électrique 20R de la Fig. 2 comporte un transformateur d'isolement 80 de structure et de fonctionnement identiques à ceux du transformateur d'isolement 70.

Si cette solution s'avère donner généralement entière satisfaction, elle ne résout pas les problèmes évoqués ci-dessus pour certaines fréquences. L'invention a pour but de résoudre ces problèmes en proposant un perfectionnement au coupleur électrique de la Fig. 2 qui permette d'améliorer la sécurité des périphériques ou alimentations connectés à ce coupleur électrique.

Pour ce faire, la présente invention concerne un coupleur électrique puissance/données du type comportant :
- un transformateur constitué d'un premier enroulement qui est prévu pour recevoir ou délivrer des signaux de données et d'un second et un troisième enroulements qui sont couplés magnétiquement entre eux et ledit premier enroulement et qui sont reliés en série entre eux avec une borne commune reliée à une ligne d'alimentation,
- un transformateur d'isolement constitué de deux enroulements identiques couplés magnétiquement entre eux,
des premières bornes desdits enroulements respectifs dudit transformateur d'isolement étant reliées aux bornes du second et du troisième enroulement dudit transformateur et des secondes bornes desdits enroulements respectifs dudit transformateur d'isolement étant reliées à un bus bifilaire.

Les enroulements desdits transformateurs sont tels que ledit coupleur électrique délivre audit bus ou recevoir dudit bus, en mode différentiel, des signaux de données et, en mode commun, le potentiel d'alimentation de ladite ligne d'alimentation.

Selon une caractéristique de l'invention, ladite borne commune auxdits second et troisième enroulements est reliée à ladite ligne d'alimentation par l'intermédiaire d'un filtre réjecteur de bande réjectant une ou des bandes de fréquences incluant la ou les fréquences de résonnance résultant de l'association du transformateur d'isolement et du transformateur.

Selon une autre caractéristique de l'invention, un coupleur selon l'invention comporte en outre un filtre passe-bas entre ledit filtre réjecteur et ladite ligne d'alimentation.

Selon une autre caractéristique de l'invention, le transformateur d'un coupleur électrique selon l'invention comporte un quatrième enroulement dont les bornes sont reliées aux premières bornes de deux enroulements identiques couplés magnétiquement et enroulés dans des sens différents d'un autre transformateur, lesdits deux enroulements ayant leurs secondes bornes reliées à une masse mécanique.

La présente invention concerne également un système de couplage qui est caractérisé en ce qu'il comporte deux coupleurs électriques tels qu'ils viennent d'être décrits, le premier desdits coupleurs électriques étant relié à un premier bus bifilaire pour y émettre des données délivrées audit premier coupleur par une unité de commande et le porter à ou y recevoir un premier potentiel d'alimentation et le second desdits coupleurs étant relié à un second bus bifilaire pour y recevoir des données et le porter à ou y recevoir un second potentiel d'alimentation, lesdites données étant délivrées par ledit second coupleur à une unité de commande.

Selon une autre caractéristique de l'invention, un système de couplage selon l'invention comporte un transformateur d'isolation galvanique dont l'enroulement primaire est connecté soit à un périphérique pour y être alimenté, soit à une source d'alimentation et dont l'enroulement est relié aux lignes d'alimentation des coupleurs électriques respectifs.

Enfin, la présente invention concerne aussi un réseau de transport de données et d'alimentation prévu pour coupler, via des bus bifilaires, des actionneurs électriques à des unités de commande et à des alimentations de puissance qui comportent une pluralité de coupleurs électriques tels qu'ils viennent d'être décrits ou une pluralité de systèmes de couplage tels qu'ils viennent d'être décrits.

Les caractéristiques de l'invention mentionnées ci-dessous, ainsi que d'autres, apparaîtront plus clairement à la lecture de la description suivante d'exemples de réalisation, ladite description étant faite en relation avec les dessins joints, parmi lesquels :
La Fig. 1 est un schéma synoptique d'un réseau de transport de données et d'alimentation qui incorpore un système de couplage pourvu de coupleurs électriques de l'état de la technique,
La Fig. 2 est un schéma synoptique d'un système de couplage incluant deux coupleurs électriques selon un mode de réalisation de l'état de la technique, perfectionnement du système de couplage de la Fig. 1,
La Fig. 3 est un schéma synoptique d'un système de couplage incluant deux coupleurs électriques selon un premier mode de réalisation de la présente invention,
La Fig. 4 est un schéma synoptique d'un système de couplage incluant deux coupleurs électriques selon un second mode de réalisation de la présente invention,
La Fig. 5 est un schéma synoptique d'un système de couplage incluant deux coupleurs électriques selon un troisième mode de réalisation de la présente invention, et
La Fig. 6 est un schéma synoptique d'un système de couplage incluant deux coupleurs électriques selon un quatrième mode de réalisation de la présente invention.

L'invention part de la constatation que les signaux parasites à hautes fréquences qui sont encore présents sur les lignes d'alimentation 22L et 21L des coupleurs électriques respectifs 20T et 20R de la Fig. 2 ont sensiblement une même fréquence F0 ou des mêmes fréquences F0 comprenant une fréquence principale et des fréquences secondaires, telles que des harmoniques ou sous-harmoniques de la fréquence de résonnance principale et que la ou chaque fréquence F0 correspond à la ou une fréquence de résonnance résultant de l'association du transformateur 70 (respectivement 80) et du transformateur 30 (respectivement 50). En effet, de manière simplifiée, à haute fréquence et en mode commun, le transformateur 70 (ou 80) est équivalent à une inductance. A haute fréquence, le transformateur 30 (ou 50), aux bornes des enroulements 32 et 33 (52 et 53), a une composante capacitive non négligeable. Cette inductance et cette composante capacitive forment ensemble un circuit résonnant (circuit bouchon) de fréquence de résonnance F0.

On notera que la ou chaque fréquence de résonnance F0 peut être déterminée expérimentalement en alimentant le transformateur 70 en mode commun (même signal sur les plots 25 et 26) et en mesurant l'amplitude du signal sur la borne commune des enroulements 32 et 33 du transformateur 30 et, ce, en fonction de la fréquence. A la fréquence de résonnance principale, cette amplitude est maximale. Des maxima d'amplitude peuvent également se présenter pour des fréquences secondaires, telles que des harmoniques ou sous-harmoniques de la fréquence de résonnance principale F0. Elle peut également être déterminée par calcul compte tenu des caractéristiques physiques constitutives des transformateurs 30 et 70 (respectivement 50 et 80). Enfin, elle peut également être déterminée par simulation au moyen d'un simulateur approprié.

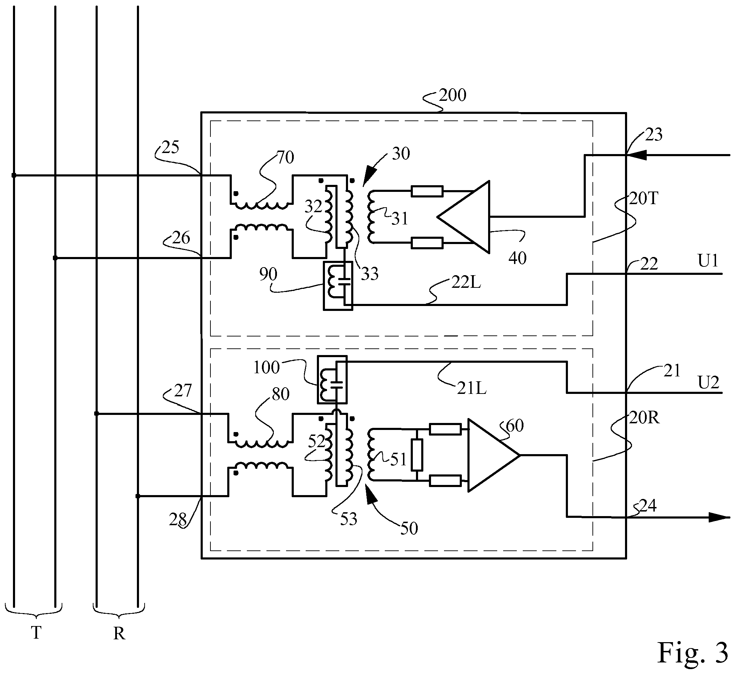

Un système de couplage selon la présente invention est destiné à être implémenté de la même manière que les systèmes de couplage 200₁ et 200₂ de la Fig. 1. Ainsi, un système de couplage 200 selon un premier mode de réalisation de la présente invention représenté à la Fig. 3 comporte les mêmes plots que les systèmes de couplage 200₁ et 200₂ des Figs. 1 et 2, en particulier des plots 25 et 26 pour l'émission de données vers un bus bifilaire T du réseau, des plots 27 et 28 pour la réception de données d'un bus bifilaire R, des plots 21 et 22 respectivement à des potentiels U2 et U1 pour, selon l'utilisation faite du système de couplage, une source d'alimentation ou un périphérique, tel que l'actionneur 10 de la Fig. 1, et des plots 23 et 24 pour respectivement recevoir des données émises par un périphérique tel qu'un actionneur ou une unité de commande ou pour émettre des données à destination d'un tel périphérique.

Comme on peut le constater, le système de couplage 200 de la Fig. 3 comporte des éléments qui sont déjà présents dans le système de couplage 200 de la Fig. 2. Ces mêmes éléments portent donc la même référence qu'à la Fig. 2 et ne sont pas ici de nouveau décrits.

Un système de couplage 200 selon un premier mode de réalisation de l'invention comporte donc deux coupleurs électriques 20T et 20R.

Le coupleur électrique 20T de la Fig. 3 diffère de celui qui est décrit en relation avec la Fig. 2 en ce qu'il comporte un filtre réjecteur de bande 90. Ce filtre réjecteur de bande 90 a une borne qui est reliée à la borne commune des enroulements 32 et 33 du transformateur 30 et l'autre borne reliée à la ligne d'alimentation 22L portant le potentiel U1. Ce filtre 90 est prévu pour réjecter une ou plusieurs bandes de fréquences incluant la ou les fréquences de résonnance F0 du transformateur d'isolement 70 et du transformateur 30. Par exemple, selon un mode de réalisation simple, le filtre 90 est constitué d'un circuit bouchon qui est formé d'une inductance et d'un condensateur (en parallèle comme ici ou en série) et dont la fréquence de résonnance F1 est égale à la fréquence de résonnance principale F0 du transformateur d'isolement 70 et du transformateur 30. A cette fréquence F1, le filtre 90 présente une très haute impédance ce qui a pour effet d'isoler le plot 22 supportant le potentiel U1 du transformateur 30, notamment de la borne commune entre ses enroulements 32 et 33.

De même, le coupleur électrique 20R représenté à la Fig. 3 comporte lui-aussi un filtre réjecteur de bande 100 dont une borne est reliée à la borne commune des enroulements 52 et 53 du transformateur 50 et l'autre borne reliée à la ligne d'alimentation 21L portant le potentiel U2. Ce filtre 100 est prévu pour réjecter une ou plusieurs bandes de fréquences incluant la ou les fréquences de résonnance F0 du transformateur d'isolement 80 et du transformateur 50. Par exemple, selon un mode de réalisation simple, le filtre 100 est lui aussi constitué d'un circuit bouchon qui est formé d'une inductance et d'un condensateur (en parallèle ou en série) et dont la fréquence de résonnance F1 est égale à la fréquence de résonnance principale F0 du transformateur d'isolement 80 et du transformateur 50. Le fonctionnement de ce filtre 100 est identique à celui du filtre 90.

Le fonctionnement est le suivant. Parmi les courants parasites à hautes fréquences qui seraient présents sur les fils des paires de fils T et R, par exemple engendrés par la foudre ou injectés lors de tests hautes fréquences, ceux qui ont une fréquence proche de la ou des fréquences F0 du transformateur d'isolement 70 (ou 80) et du transformateur 30 (respectivement 50) sont d'amplitude relativement élevée sur la borne commune des enroulements 32 et 33 (respectivement 52 et 53) du fait de la résonnance au niveau des transformateurs 70 (ou 80) et 30 (ou 50) mais sont réjectés par les filtres respectifs 90 et 100 et ne se retrouvent donc pas sur les lignes d'alimentation 21L et 22L connectées aux plots 21 et 22, ce qui est une sécurité pour les périphériques connectés à ces plots 21 et 22.

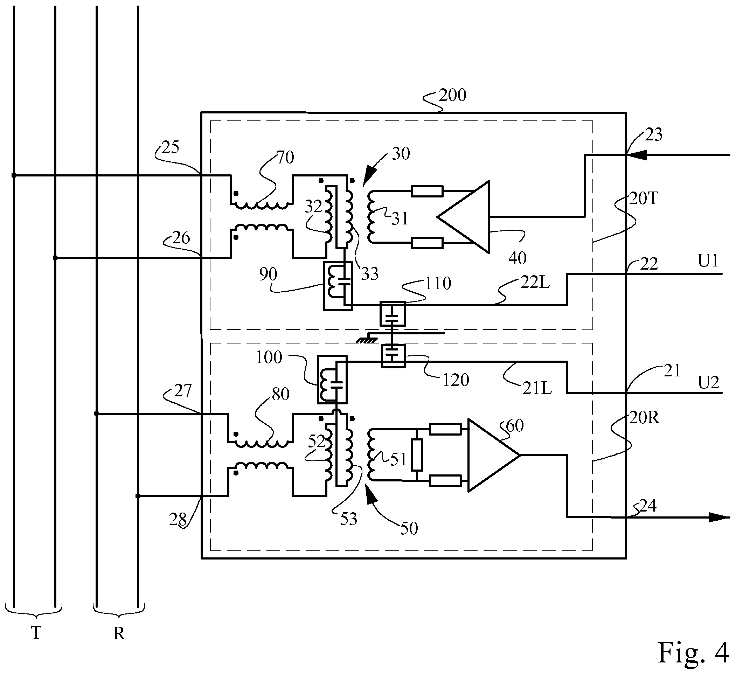

Dans le mode de réalisation représenté à la Fig. 4, chaque coupleur électrique 20T, 20R comporte de plus un filtre passe-bas 110, 120 entre ledit filtre réjecteur 90, 100 et la ligne d'alimentation 22L, 21L portant le potentiel d'alimentation U1, U2 correspondant. Dans un exemple de réalisation, le filtre passe-bas 110 est constitué d'un simple condensateur qui est prévu entre la ligne d'alimentation 22L supportant le potentiel U1 et la masse mécanique de l'appareil de manière à minimiser les signaux hautes fréquences sur cette ligne 22L. De même, pour la voie correspondant au bus bifilaire R, le filtre passe-bas 120 est constitué d'un condensateur prévu entre la ligne d'alimentation 21L portant le potentiel U2 et la masse mécanique de l'appareil de manière de manière à aussi minimiser les signaux hautes fréquences sur cette ligne 21L.

Chaque condensateur 110, 120, dont l'impédance est faible à très haute fréquence, forme un pont diviseur avec le filtre réjecteur correspondant 100, 110, minimisant encore la tension haute-fréquence, en particulier à la fréquence de résonnance F0 du transformateur d'isolement 70 et du transformateur 30, 50 30, 50, à la borne supportant le potentiel U1, U2.

La fréquence de coupure des filtres passe-bas 110, 120 est inférieure à la fréquence de résonnance la plus basse résultant de l'association du transformateur d'isolement 70, 80 et le transformateur 30, 50 et supérieure à la fréquence des potentiels U1 et U2 si ceux-ci sont alternatifs.

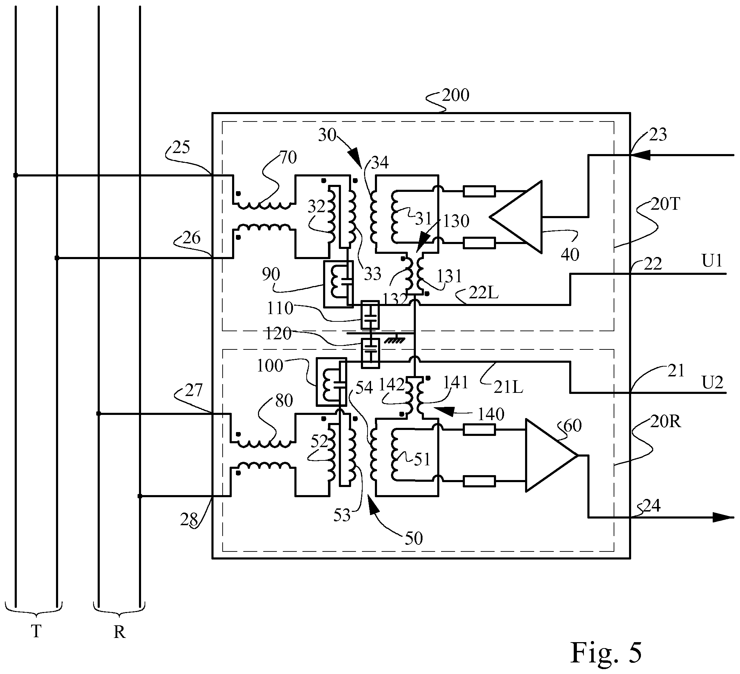

On a représenté à la Fig. 5 un troisième mode de réalisation de l'invention. Selon ce mode de réalisation, il diffère de celui qui a été décrit en relation avec la Fig. 4 en ce que le transformateur 30 du coupleur électrique 20T comporte maintenant un quatrième enroulement 34 dont les bornes sont respectivement reliées aux premières bornes de deux enroulements identiques 131 et 132 d'un transformateur 130 dont les secondes bornes sont reliées à la masse mécanique de l'appareil dans lequel est installé le coupleur électrique considéré. Les enroulements 131 et 132 sont couplés magnétiquement et sont enroulés dans des sens différents (voir points symboliques liés à ces enroulements). De même, le transformateur 50 du coupleur électrique 20R comporte un quatrième enroulement 54 dont les bornes sont respectivement reliées aux premières bornes de deux enroulements identiques 141 et 142 d'un transformateur 140 dont les secondes bornes sont reliées à la masse mécanique de l'appareil dans lequel est installé le coupleur électrique considéré. Les enroulements 141 et 142 sont couplés magnétiquement et sont enroulés dans des sens différents (voir points symboliques liés à ces enroulements).

L'enroulement 34 forme un écran capacitif entre le premier enroulement 31, d'une part, et les second et troisième enroulements 32 et 33, d'autre part, ce qui a pour effet d'augmenter substantiellement la fréquence de résonnance principale F0 liée aux capacités équivalentes du transformateur 30. Par ailleurs, parmi les courants hautes fréquences qui seraient présents sur les fils de la paire de fils T, par exemple engendrés par la foudre ou injectés lors de tests hautes fréquences, ceux qui présentent une fréquence de résonnance F0 sont d'amplitude élevée du fait de la résonnance due au transformateur d'isolement 70 et au transformateur 30. Ils excitent l'enroulement 34 qui les aiguille vers la masse mécanique via les enroulements 131 et 132 du transformateur 130 qui, en mode commun, présentent une impédance faible. L'amplificateur 40 est ainsi protégé contre des surtensions pouvant apparaître aux bornes de l'enroulement 31 du transformateur 30. En dehors de ces fréquences, les enroulements 131 et 132 présentent une impédance élevée si bien que l'enroulement 34 ne forme plus écran. Le fonctionnement de l'amplificateur 40 n'est alors pas perturbé par la présence de l'enroulement 34.

De même, l'enroulement 54 forme un écran capacitif entre le premier enroulement 51, d'une part, et les second et troisième enroulements 52 et 53, d'autre part, ce qui a pour effet d'augmenter substantiellement la fréquence de résonnance principale F0 liée aux capacités équivalentes du transformateur 50. De plus, parmi les courants hautes fréquences qui seraient présents sur les fils de la paire de fils R, par exemple engendrés par la foudre ou injectés lors de tests hautes fréquences, ceux qui présentent une fréquence de résonnance F0 sont d'amplitude élevée du fait de la résonnance due au transformateur d'isolement 80 et au transformateur 50. Ils excitent l'enroulement 54 qui les aiguille vers la masse mécanique via les enroulements 141 et 142 du transformateur 140 qui, en mode commun, présentent une impédance faible. En dehors de ces fréquences, les enroulements 141 et 142 présentent une impédance élevée si bien que l'enroulement 54 ne forme plus écran.

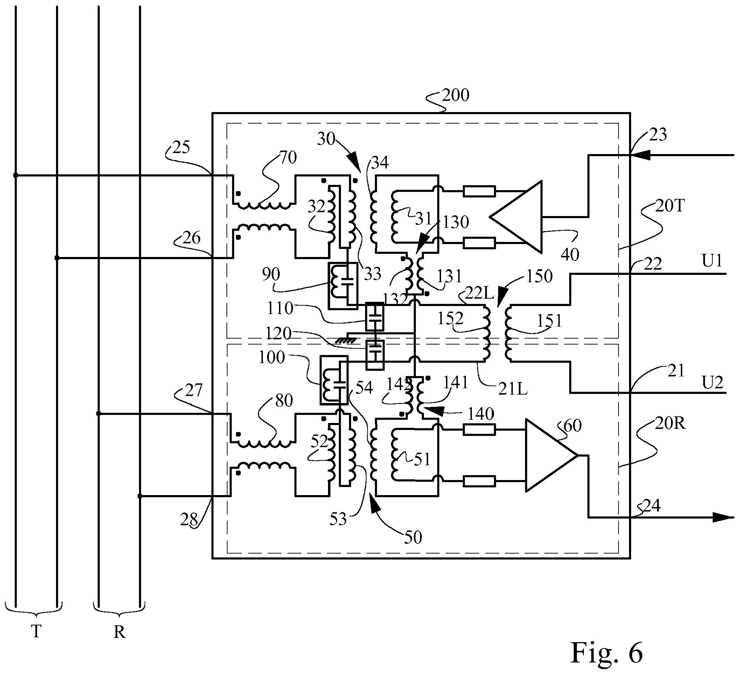

Les systèmes de couplage, objets des Figs. 2 à 5, sont prévus pour une alimentation, via les potentiels d'alimentation U1 et U2, aussi bien en continu qu'en alternatif basse fréquence (par exemple inférieure à 1 MHz, c'est-à-dire inférieure de plusieurs ordres de grandeurs à la fréquence des signaux de données (par exemple supérieure à 100 MHz). Le mode de réalisation de la Fig. 6 prévoit un mode d'alimentation exclusivement alternatif. Par rapport aux modes de réalisation des Figs. 3 à 5, le mode de réalisation de la Fig. 6 comprend un transformateur d'isolation galvanique 150 dont l'enroulement primaire 151 est relié aux plots 22 et 21 sur lesquels est connecté soit un périphérique (non représenté) pour y être alimenté, soit une source d'alimentation (non représentée) et dont l'enroulement 152 est relié aux lignes d'alimentation 22L et 21L, ici les sorties respectives des filtres 90 et 100. Dans le mode de réalisation de la Fig. 6, tous les éléments du mode de réalisation de la Fig. 5 sont présents. Mais on comprendra que ce transformateur 150 pourrait aussi être monté pareillement dans les coupleurs électriques des modes de réalisation des Figs. 3 et 4.

De plus, on notera également que le transformateur 150 pourrait ne pas être inclus au coupleur électrique 200 et ainsi être monté à distance de ce coupleur électrique 200.

On a décrit les coupleurs électriques 20T et 20R comme faisant partie d'un même système de couplage comportant donc deux coupleurs électriques, l'un 20T dédié à l'émission de signaux de données sur le bus bifilaire T et l'autre 20R, dédié à la réception de signaux de données présents sur le bus bifilaire R. La présente invention porte sur les coupleurs électriques tels qu'ils viennent d'être décrits, qu'ils soient parties d'un système de couplage ou au contraire isolés.

## Revendications

1. Coupleur électrique puissance/données (20T; 20R) du type comportant :
- un transformateur (30; 50) constitué d'un premier enroulement (31; 51) qui est prévu pour recevoir ou délivrer des signaux de données et d'un second et un troisième enroulements (32 et 33; 52 et 53) qui sont couplés magnétiquement entre eux et ledit premier enroulement (31;51) et qui sont reliés en série entre eux avec une borne commune reliée à une ligne d'alimentation (22L; 21L),
- un transformateur d'isolement (70;80) constitué de deux enroulements identiques couplés magnétiquement entre eux,
des premières bornes desdits enroulements respectifs dudit transformateur d'isolement (70;80) étant reliées aux bornes du second et du troisième enroulement dudit transformateur (30; 50) et des secondes bornes desdits enroulements respectifs dudit transformateur d'isolement (70;80) étant reliées à un bus bifilaire (T; R),
les enroulements desdits transformateurs (30; 50; 70; 80) étant tels que ledit coupleur électrique délivre audit bus (T) ou recevoir dudit bus (R), en mode différentiel, des signaux de données et, en mode commun, le potentiel d'alimentation (U1; U2) de ladite ligne d'alimentation, **caractérisé en ce que** ladite borne commune auxdits second et troisième enroulements (32 et 33; 52 et 53) est reliée à ladite ligne d'alimentation (22L; 21L) par l'intermédiaire d'un filtre réjecteur de bande (90; 100), ledit filtre (90; 100) réjectant une ou des bandes de fréquences incluant la ou les fréquences de résonnance résultant de l'association du transformateur d'isolement (70;80) et du transformateur (30; 50).

2. Coupleur électrique selon la revendication 1, **caractérisé en ce qu'**il comporte en outre, un filtre passe-bas (110; 120) entre ledit filtre réjecteur (90; 100) et ladite ligne d'alimentation (22L; 21L).

3. Coupleur électrique selon la revendication 1 ou 2, **caractérisé en ce que** ledit transformateur (30; 50) comporte un quatrième enroulement (34; 54) dont les bornes sont reliées aux premières bornes de deux enroulements identiques (131 et 132; 141 et 142) couplés magnétiquement et enroulés dans des sens différents d'un autre transformateur (130; 140), lesdits deux enroulements (131 et 132; 141 et 142) ayant leurs secondes bornes reliées à une masse mécanique.

4. Système de couplage (200), **caractérisé en ce qu'**il comporte deux coupleurs électriques (20T et 20R) selon une des revendications précédentes, le premier (20T) desdits coupleurs électriques étant relié à un premier bus bifilaire (T) pour y émettre des données délivrées audit premier coupleur (20T) par une unité de commande et le porter à ou y recevoir un premier potentiel d'alimentation (U1) et le second (20R) desdits coupleurs étant relié à un second bus bifilaire (R) pour y recevoir des données et le porter à ou y recevoir un second potentiel d'alimentation (U2), lesdites données étant délivrées par ledit second coupleur (20R) à une unité de commande.

5. Système de couplage selon la revendication 4, **caractérisé en ce qu'**il comporte un transformateur d'isolation galvanique (150) dont l'enroulement primaire (151) est connecté soit à un périphérique pour y être alimenté, soit à une source d'alimentation, et dont l'enroulement secondaire (152) est relié aux lignes d'alimentation des coupleurs électriques respectifs.

6. Réseau de transport de données et d'alimentation prévu pour coupler, via des bus bifilaires, des actionneurs électriques à des unités de commande et à des alimentations de puissance, **caractérisé en ce qu'**il comporte une pluralité de coupleurs électriques selon une des revendications 1 à 3 ou une pluralité de systèmes de couplage selon la revendication 4 ou 5.

## Patentansprüche

1. Elektrischer Leistungs-/Datenkoppler (20T; 20R) von der Art, die aufweist:
- einen Transformator (30; 50), der aus einer ersten Wicklung (31; 51), die vorgesehen ist, Datensignale zu empfangen oder zu liefern, und aus einer zweiten und dritten Wicklung (32 und 33; 52 und 53) besteht, die magnetisch untereinander und mit der ersten Wicklung (31; 51) gekoppelt sind, und die miteinander in Reihe geschaltet sind mit einer gemeinsamen Klemme, die mit einer Versorgungsleitung (22L; 21L) verbunden ist,
- einen Trenntransformator (70; 80), der aus zwei magnetisch miteinander gekoppelten gleichen Wicklungen besteht,
wobei erste Klemmen der jeweiligen Wicklungen des Trenntransformators (70; 80) mit den Klemmen der zweiten und dritten Wicklung des Transformators (30; 50) verbunden sind, und zweite Klemmen der jeweiligen Wicklungen des Trenntransformators (70; 80) mit einer Zweidraht-Busleitung (T; R) verbunden sind,
wobei die Wicklungen der Transformatoren (30; 50; 70; 80) so sind, dass der elektrische Koppler im Gegentaktbetrieb Datensignale an die Busleitung (T) liefert oder von der Busleitung (R) empfängt und im Gleichtaktbetrieb das Versorgungspotential (U1; U2) der Versorgungsleitung, **dadurch gekennzeichnet, dass** die den zweiten und dritten Wicklungen (32 und 33; 52 und 53) gemeinsame Klemme mit der Versorgungsleitung (22L; 21L) mittels eines Bandsperrfilters (90; 100) verbunden ist, wobei der Filter (90; 100) eines oder mehrere Frequenzbänder sperrt, die die Resonanzfrequenz(en) umfassen, die aus der Verbindung des Trenntransformators (70; 80) und des Transformators (30; 50) resultieren.

2. Elektrischer Koppler nach Anspruch 1, **dadurch gekennzeichnet, dass** er außerdem einen Tiefpassfilter (110; 120) zwischen dem Sperrfilter (90; 100) und der Versorgungsleitung (22L; 21L) aufweist.

3. Elektrischer Koppler nach Anspruch 1 oder 2, **dadurch gekennzeichnet, dass** der Transformator (30; 50) eine vierte Wicklung (34; 54) aufweist, deren Klemmen mit den ersten Klemmen von zwei gleichen Wicklungen (131 und 132; 141 und 142) eines anderen Transformators (130; 140) verbunden sind, die magnetisch gekoppelt und in unterschiedliche Richtungen gewickelt sind, wobei die zweiten Klemmen der zwei Wicklungen (131 und 132; 141 und 142) mit einer mechanischen Masse verbunden sind.

4. Kopplungssystem (200), **dadurch gekennzeichnet, dass** es zwei elektrische Koppler (20T und 20R) nach einem der vorhergehenden Ansprüche aufweist, wobei der erste (20T) der elektrischen Koppler mit einer ersten Zweidraht-Busleitung (T) verbunden ist, um dort Daten zu senden, die an den ersten Koppler (20T) von einer Steuereinheit geliefert werden, und ihn auf ein erstes Versorgungspotential (U1) zu bringen oder es dort zu empfangen, und der zweite (20R) der Koppler mit einer zweiten Zweidraht-Busleitung (R) verbunden ist, um dort Daten zu empfangen und ihn auf ein zweites Versorgungspotential (U2) zu bringen oder dort zu empfangen, wobei die Daten vom zweiten Koppler (20R) an eine Steuereinheit geliefert werden.

5. Kopplungssystem nach Anspruch 4, **dadurch gekennzeichnet, dass** es einen galvanischen Trenntransformator (150) aufweist, dessen Primärwicklung (151) entweder mit einem Peripheriegerät, um dort versorgt zu werden, oder mit einer Versorgungsquelle verbunden ist, und dessen Sekundärwicklung (152) mit den Versorgungsleitungen der jeweiligen elektrischen Koppler verbunden ist.

6. Datentransport- und Versorgungsnetz, das vorgesehen ist, um über Zweidraht-Busleitungen elektrische Stellglieder mit Steuereinheiten und Leistungsversorgungen zu koppeln, **dadurch gekennzeichnet, dass** es eine Vielzahl von elektrischen Kopplern nach einem der Ansprüche 1 bis 3 oder eine Vielzahl von Kopplungssystemen nach Anspruch 4 oder 5 aufweist.

## Claims

1. Power/data electrical coupler (20T; 20R) of the type comprising:
- a transformer (30; 50) consisting of a first winding (31; 51) which is designed to receive or deliver data signals and second and third windings (32 and 33; 52 and 53) which are magnetically coupled to each other and said first winding (31; 51) and which are connected in series with each other with a common terminal connected to a power supply line (22L; 21L),
- an isolation transformer (70; 80) consisting of two identical windings magnetically coupled to each other,
first terminals of said respective windings of said isolation transformer (70; 80) being connected to the terminals of the second and third winding of said transformer (30; 50) and second terminals of said respective windings of said isolation transformer (70; 80) being connected to a two-wire bus (T; R),
the windings of said transformers (30; 50; 70; 80) being such that said electrical coupler delivers to said bus (T) or receives from said bus (R), in differential mode, data signals and, in common mode, the power supply potential (U1; U2) of said power supply line, **characterised in that** said terminal common to said second and third windings (32 and 33; 52 and 53) is connected to said power supply line (22L; 21L) by means of a band-rejection filter (90; 100), said filter (90; 100) rejecting one or more frequency bands including the resonant frequency or frequencies resulting from the association of the isolation transformer (70; 80) and the transformer (30; 50).

2. Electrical coupler according to claim 1, **characterised in that** it further comprises a low-pass filter (110; 120) between said rejection filter (90; 100) and said power supply line (22L; 21L).

3. Electrical coupler according to claim 1 or claim 2, **characterised in that** said transformer (30; 50) comprises a fourth winding (34; 54), the terminals of which are connected to the first terminals of two identical windings (131 and 132; 141 and 142) coupled magnetically and wound in directions different from another transformer (130; 140), said two windings (131 and 132; 141 and 142) having their second terminals connected to a mechanical earth.

4. Coupling system (200), **characterised in that** it comprises two electrical couplers (20T and 20R) according to any of the preceding claims, the first (20T) of said electrical couplers being connected to a first two-wire bus (T) in order to send thereon data delivered to said first coupler (20T) by a control unit and to raise it to or receive thereon a first supply potential (U1), and the second (20R) of said couplers being connected to a second two-wire bus (R) in order to receive data thereon and to raise it to or receive thereon a second supply potential (U2), said data being delivered by said second coupler (20R) to a control unit.

5. Coupling system according to claim 4, **characterised in that** it comprises a galvanic isolation transformer (150), the primary winding (151) of which is connected either to a peripheral in order to be supplied thereon, or to a supply source, and the secondary winding (152) of which is connected to the power supply lines of the respective electrical couplers.

6. Data and power-supply transport network designed, via two-wire buses, to couple electrical actuators to control units and to power supplies, **characterised in that** it comprises a plurality of electrical couplers according to any of claims 1 to 3 or a plurality of coupling systems according to claim 4 or 5.
